# FASCICULE DE BREVET EUROPEEN

(11) **EP 0 642 058 B1**
(45) Date de publication et mention de la délivrance du brevet: **12.03.1997**
(21) Numéro de dépôt: 94470023.6
(22) Date de dépôt: 03.08.1994
(51) Int. Cl.: G03F 7/30

(54) **Procédé et dispositif pour la séparation en continu des constituants d'un bain de gravure**
Verfahren und Gerät zur kontinuierlichen Trennung von Bestandteilen eines Entwicklerbades
Process and apparatus for continuous separation of ingrédients from a developing bath

(30) Priorité: 19.08.1993 FR 9310253
(43) Date de publication de la demande: 08.03.1995
(73) Titulaire: PHOTOMECA S.A., 54340 Pompey (FR)
(72) Inventeur: Ferrante, Mario, F-54520 Laxou (FR)
(74) Mandataire: Poupon, Michel

(56) Documents cités:
- EP-A- 0 430 233
- DE-A- 3 143 106
- FR-A- 2 558 078

## Description

La présente invention concerne une machine perfectionnée de gravure pour la fabrication d'un cliché photopolymère utilisable pour la réalisation d'imprimés en flexographie, typographie ou offset sec, elle concerne également un procédé pour la séparation des composants du bain de gravure contenu dans ladite machine.

On sait déjà que l'on peut obtenir un cliché pour la flexographie ou la typographie, en exposant une plaque de photopolymère sensible aux rayonnements ultraviolets, avec l'interposition d'un film négatif qui laisse exposées au rayonnement les zones qui doivent venir en relief sur le cliché terminé, ceci constitue l'étape d'impression.

Le rayonnement durcit ces zones et on élimine ensuite la matière de la surface protégée en la brossant à l'aide de brosses planes ou rotatives ou par buses de pulvérisation ; un solvant ou de l'eau faisant office d'agent mouillant, on poursuit l'opération jusqu'à ce que les zones qui ont été exposées se trouvent suffisamment en relief, ceci constitue l'étape de gravure proprement dite.

Au cours de la gravure, l'eau se charge puis se sature en particules de polymère dissoutes et/ou en suspension, il faut donc procéder régulièrement à un changement du bain de gravure.

Un problème se pose concernant la solution saturée qu'il faut traiter dans un dispositif de traitement indépendant de la machine de gravure, puis rejeter. Le traitement de la solution ne permettant jamais d'éliminer totalement les particules de polymères, un problème se pose au niveau de la protection de l'environnement.

Les bacs de gravure connus présentent en outre d'autres inconvénients :
- encrassement des brosses : il faut procéder à un nettoyage régulier du matériel,
- diminution du volume du bain par évaporation : d'où augmentation plus rapide de la concentration en polymère et nécessité d'ajouter des compléments d'eau,
- augmentation du temps de gravure en fonction de l'encrassement et/ou de l'évaporation du bain.

Par ailleurs, on connait des dispositifs voir EP-430.233 et DE-3.238.134 avec un bac de gravure et un circuit de séparation des composants du bain de gravure prélevant ce bain de gravure et en le réinjectant dans le bac en continu après séparation des composants.

Dans le document EP-430.233 on réalise la séparation par des moyens de décantation ou de filtration qu'il est impossible de remplacer en cours de gravure lorsqu'ils sont saturés, d'où la survenue de pannes et la nécessité d'arrêter la circulation du liquide pour procéder au remplacement.

Dans le document DE-3.238.134, la séparation est réalisée par une succession de bacs de décantation dans une installation compliquée et encombrante.

L'invention a pour but de trouver une solution au problème posé en palliant tous les inconvénients précités.

La solution selon l'invention consiste en un procédé pour la confection de clichés souples, utilisables pour la réalisation d'imprimés en flexographie, typographie ou offset sec, du type comportant:
- une étape de polymérisation de zones par exposition aux rayonnements ultraviolets,
- une étape de gravure des zones non polymérisées par immersion et brossage dans un bain de gravure contenu dans un bac de gravure, ledit bain se chargeant de particules dissoutes ou en suspension pendant l'étape de gravure,
- une séparation des composants du bain de gravure avec réinjection dans le bac de gravure du liquide obtenu lors de la séparation, cette séparation consistant en une filtration avec élimination des particules au fur et à mesure de la filtration,
caractérisé en ce que l'élimination des particules par remplacement du filtre réalisant la filtration est automatique.

Un dispositif de gravure pour la confection de clichés souples utilisables pour la réalisation d'imprimés en flexographie, typographie ou offset sec du type comportant :
- un bac de gravure contenant un bain et des brosses,
- un dispositif de séparation des composants du bain fonctionnant en bouche fermée avec réinjection dans le bac de gravure du liquide obtenu après séparation des composants du bain,

le dispositif de séparation comportant un moyen de séparation formé d'un filtre pouvant être remplacé pendant la gravure au fur et à mesure de sa saturation et le dispositif de séparation étant formé principalement d'un système de trop plein pour évacuer la solution du bac de gravure par une canalisation de sortie au dessus d'un moyen de filtration d'un bac de réception, le liquide obtenu après séparation dans ledit bac étant réinjecté dans le bac de gravure au moyen d'une pompe, caractérisé en ce que le moyen de séparation est formé d'une bande de filtre provenant d'un rouleau d'alimentation et pouvant être déroulée de façon à remplacer la partie saturée de la bande.

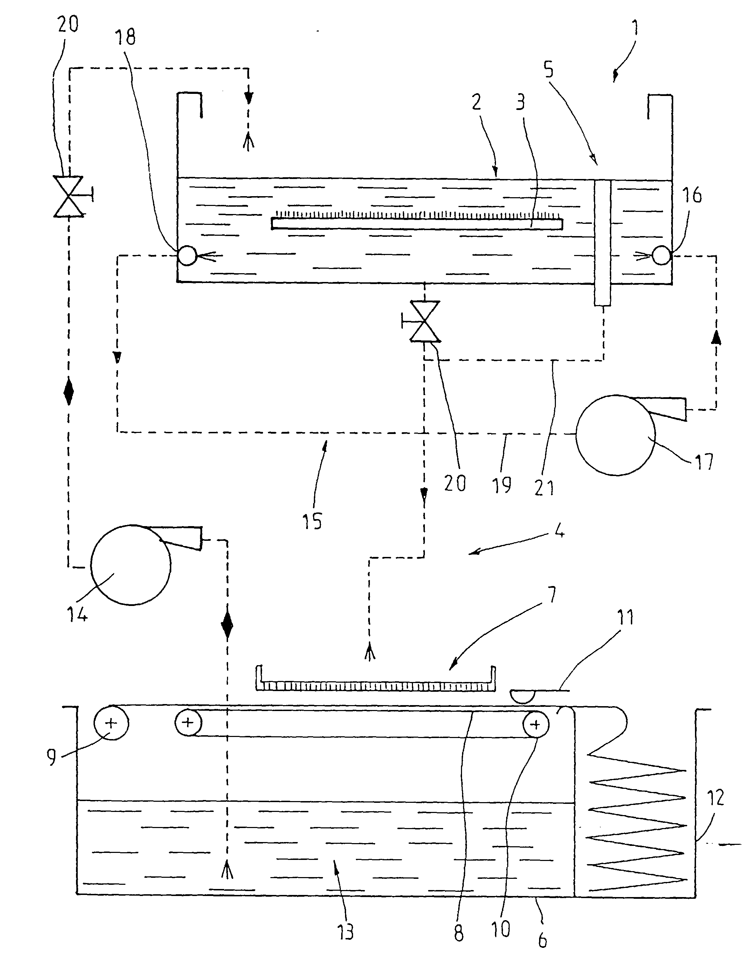

On comprendra mieux l'invention à l'aide de la description qui suit faite en référence à la figure unique annexée.

La figure unique est un shéma de principe d'un exemple non limitatif de mise en oeuvre du procédé.

Une machine à graver selon l'invention comporte en combinaison :
- un bac de gravure (1) contenant un bain (2) et des brosses (3),
- un dispositif de séparation (4) des composants du bain fonctionnant automatiquement en continu et en boucle fermée.

Le bac de gravure (1) comporte un système de trop plein (5) évacuant la solution par une canalisation de sortie (21) vers le dispositif de séparation (4).

Ce dispositif de séparation (4) est formé principalement d'un bac de réception (6) dont la partie haute est équipée d'un moyen de séparation (7) de l'eau et du polymère.

Selon un mode de réalisation préféré, le moyen de séparation (7) est une bande de filtre (8) provenant d'un rouleau d'alimentation (9) et pouvant être automatiquement déroulée par un système d'avance (10) à rouleaux et chaînes.

La bande de filtre (8) reçoit et filtre la solution en provenance du bac après passage dans une grille ou tamis (20). Lorsque la bande (8) est saturée, le niveau de la solution monte et soulève un flotteur (11) formant détecteur de saturation de filtre.

Le flotteur (11) commande alors le système d'avance (10) qui met en place une nouvelle bande de filtre, la bande saturée étant évacuée dans un bac de stockage (12).

Bien entendu, en variante, on peut prévoir un moyen de déroulement manuel de la bande de filtre.

En outre, la texture, la porosité, le matériau du filtre sont choisis en fonction du mélange liquide/particules que l'on doit filtrer.

Le produit filtré (13) récupéré dans le bac de récéption (6) est pompé par une pompe (14) et réinjecté en haut du bac de gravure (1).

On constate une légère baisse de niveau dans le bac de gravure en raison de l'évaporation. Cette évaporation est facilement compensée en ajoutant de l'eau dans le bac de réception (6) par exemple, on prévoit un volume dans le bac (6) double de celui du bac de gravure (1). Le volume du bac (6) faisant fonction de volume tampon.

On perfectionne encore la machine en y ajoutant un dispositif (15) de brassage de la solution du bain comportant une vanne de sortie (16), une pompe de circulation (17), une vanne d'injection (18) et une canalisation extérieure (19).

Le dispositif de brassage (15) rend homogène la concentration de la solution du bain, diminue les dépôts de particules en fond de bac, évite l'encrassement des brosses.

Bien entendu, la machine comporte encore des aménagements classiques : par exemple vannes de vidange (20), dispositifs de commande et de sécurité non représentés.

Les avantages et performances de la machine sont nombreux et notamment :
- suppression du problème de rejet des eaux usées jounalières,
- économie d'eau,
- système entièrement automatique donc suppression des manipulations journalières des systèmes de filtration de l'art antérieur,
- propreté pratiquement constante de la cuve et des brosses,
- niveau constant dans la cuve de gravure par compensation des évaporations, d'où une hauteur de solution constante au dessus des brosses, assurant une qualité constante de leur nettoyage,
- gain en surface au sol par rapport à l'art antérieur qui nécessitait, en plus de la machine, toute une installation de traitement,
- saturation pratiquement constante du bain d'où un temps de gravure pratiquement constant,
- économie de maintenance et d'entretien.

## Revendications

1. Procédé pour la confection de clichés souples, utilisables pour la réalisation d'imprimés en flexographie, typographie ou offset sec, du type comportant:
- une étape de polymérisation de zones par exposition aux rayonnements ultraviolets,
- une étape de gravure des zones non polymérisées par immersion et brossage dans un bain de gravure contenu dans un bac de gravure, ledit bain se chargeant de particules dissoutes ou en suspension pendant l'étape de gravure,
- une séparation des composants du bain de gravure avec réinjection dans le bac de gravure du liquide obtenu lors de la séparation, cette séparation consistant en une filtration avec élimination des particules au fur et à mesure de la filtration,
caractérisé en ce que l'élimination des particules par remplacement du filtre réalisant la filtration est automatique.

2. Procédé selon la revendication 1, caractérisé en ce que l'on injecte en plus du liquide obtenu par séparation, une quantité d'eau destinée à compenser l'évaporation.

3. Dispositif de gravure pour la confection de clichés souples utilisables pour la réalisation d'imprimés en flexographie, typographie ou offset sec du type comportant:
- un bac de gravure contenant un bain (2) et des brosses (3),
- un dispositif de séparation (4) des composants du bain fonctionnant en bouche fermée avec réinjection dans le bac de gravure du liquide obtenu après séparation des composants du bain,
le dispositif de séparation (4) comportant un moyen de séparation (7) formé d'un filtre pouvant être remplacé pendant la gravure au fur et à mesure de sa saturation et le dispositif de séparation (4) étant formé principalement d'un système de trop plein (5) pour évacuer la solution du bac de gravure par une canalisation de sortie (21) au dessus d'un moyen de filtration (4) d'un bac de réception (6), le liquide obtenu après séparation dans ledit bac étant réinjecté dans le bac de gravure au moyen d'une pompe (14), caractérisé en ce que le moyen de séparation (7) est formé d'une bande de filtre (8) provenant d'un rouleau d'alimentation (9) et pouvant être déroulée de façon à remplacer la partie saturée de la bande.

4. Dispositif selon la revendication précédente, caractérisé en ce que la bande de filtre est déroulée automatiquement sur commande d'un détecteur de saturation de filtre.

5. Dispositif selon la revendication précédente, caractérisé en ce qu'il comporte un bac de stockage (12) dans lequel est évacuée la bande de filtre saturée.

6. Dispositif selon l'une des revendications 3 à 5, caractérisé en ce qu'il comporte en outre un dispositif de brassage (15) du bain formé d'une canalisation extérieure (19) et d'une pompe de circulation (17).

7. Dispositif selon l'une des revendications 3 à 6, caractérisé en ce que le volume de liquide dans le bac de récupération (6) est plus important que celui du bac de gravure, de manière à compenser les évaporations.

## Patentansprüche

1. Verfahren zur Herstellung von flexiblen Druckstöcken, die zur Herstellung von Drucken im Flexodruck, im Hochdruck oder im Trockenoffsetdruck einsetzbar sind,
- mit einem Polymerisationsschritt von vorbestimmten Bereichen durch Aussetzen dieser Bereiche gegenüber ultravioletter Strahlung,
- mit einem Gravüreschritt der nicht polymerisierten Bereiche durch Eintauchen und Bürsten in einem Gravürebad, welches sich in einem Gravürebecken befindet, wobei das genannte Bad sich während des Gravüreschrittes an gelösten oder in Suspension befindlichen Teilchen anreichert,
- mit einer Trennung der Bestandteile des Gravürebades mit einer Wiedereinfüllung der bei der Trennung gewonnenen Flüssigkeit in das Gravürebecken, wobei diese Trennung aus einer Filtrierung mit einer Entfernung der Teilchen während des Ablaufes der Filtrierung besteht,
**dadurch gekennzeichnet**, daß die Entfernung der Teilchen durch einen Ersatz des Filters, der die Filtrierung gewährleistet, automatisch stattfindet

2. Verfahren nach Anspruch 1, dadurch gekennzeichnet, daß über die während der Trennung gewonnene Flüssigkeit hinaus eine Menge Wasser hinzugefüllt wird, die dazu vorgesehen ist, die Verdunstung zu kompensieren.

3. Vorrichtung zur Herstellung von flexiblen Druckstöcken, die zur Herstellung von Drucken im Flexodruck, im Hochdruck oder im Trockenoffsetdruck einsetzbar sind,
- mit einem Gravürebecken mit einem Bad (2) und Bürsten (3),
- mit einer Einrichtung (4) zum Trennen der Bestandteile des Bades in einem geschlossenen Kreislauf mit einer Wiedereinfüllung des nach der und durch die Trennung der Bestandteile erhaltenen Flüssigkeit in das Gravürebecken,
- wobei die Einrichtung (4) zum Trennen ein Trennmittel (7) aufweist, welches aus einem Filter besteht, der während der Gravüre nach seiner nach und nach ansteigenden Sättigung ersetzt wird, und wobei die Einrichtung (4) zum Trennen im wesentlichen aus einem Überlaufsystem (5) besteht, um die Lösung des Gravürebades über eine Ausgangsleitung (21) über ein Filtermittel (4) eines Aufnahmebehälters (6) zu leiten, wobei die nach der Trennung in dem Aufnahmebehälter erhaltene Flüssigkeit mit Hilfe einer Pumpe (14) in das Gravürebad zurückgefüllt wird, **dadurch gekennzeichnet**, daß das Trennmittel (7) aus einem Filterstreifen (8) besteht, der von einer Vorratsrolle (9) abgewickelt wird und in einer solchen Weise ausgerollt wird, daß der gesättigte Abschnitt des Streifens ersetzt wird.

4. Vorrichtung nach vorstehendem Anspruch 3, dadurch gekennzeichnet, daß der Filterstreifen nach Auslösung eines Sättigungsanzeigesensors automatisch abwickelbar ist

5. Vorrichtung nach vorstehendem Anspruch 4, dadurch gekennzeichnet, daß ein Vorratsbecken (12) vorgesehen ist, in welches der gesättigte Filterstreifen geführt wird.

6. Vorrichtung nach einem der Ansprüche 3 bis 5, dadurch gekennzeichnet, daß eine Umwälzeinrichtung (15) für das Bad vorgesehen ist, die aus einer äußeren Leitung (19) und einer Umwälzpumpe (17) besteht

7. Vorrichtung nach einem der Ansprüche 3 bis 6, dadurch gekennzeichnet, daß das Flüssigkeitsvolumen in dem Aufnahmebehälter (6) größer als das des Gravürebeckens ist, um auftretende Verdunstungen zu kompensieren.

## Claims

1. Method for the manufacture of flexible printing blocks which can be used for the production of printed matter by flexography, typography or dry offset printing, of the type including:
- a polymerisation step for polymerising areas by exposing them to ultraviolet rays,
- an engraving step for engraving the non-polymerised areas by immersion and brushing in an engraving bath contained in an engraving tank, said bath becoming charged with dissolved particles or particles in suspension during the engraving step,
- a separation of the constituents of the engraving bath with re-injection into the engraving tank of the liquid obtained during the separation, this separation comprising a filtration with the progressive elimination of the particles during the filtration,
characterised in that the elimination of the particles by replacement of the filter effecting the filtration is automatic.

2. Method according to claim 1, characterised in that, in addition to the liquid obtained by separation, a quantity of water is injected, which is intended to compensate for the evaporation.

3. Engraving device for the manufacture of flexible printing blocks, which can be used for the production of printed matter by flexography, typography or dry offset printing, of the type including:
- an engraving tank containing a bath (2) and brushes (3),
- a separation device (4) for separating the constituents of the bath operating as a closed mouth with re-injection into the engraving tank of the liquid obtained after separation of the constituents of the bath,
the separation device (4) comprising a separating means (7) formed by a filter, said filter being replaceable during the engraving as it becomes progressively saturated, and the separation device (4) being formed principally by an overflow system (5) to evacuate the solution from the engraving tank by an outlet pipe (21) above a filtration means (4) of a reception tank (6), the liquid obtained after separation in said tank being re-injected into the engraving tank by means of a pump (14), characterised in that the separating means (7) is formed by a filter tape (8) which is fed from a supply roll (9) and can be unrolled so as to replace the saturated portion of the tape.

4. Device according to the preceding claim, characterised in that the filter tape is unrolled automatically, actuated by a filter saturation detector.

5. Device according to the preceding claim, characterised in that it comprises a storage tank (12), into which the saturated filter tape is evacuated.

6. Device according to one of claims 3 to 5, characterised in that it also comprises a mixing device (15) for the bath, which mixing device is formed by an external pipe (19) and a circulation pump (17).

7. Device according to one of claims 3 to 6, characterised in that the volume of liquid in the recovery tank (6) is greater than that in the engraving tank, so as to compensate for the evaporation.
